# EUROPEAN PATENT APPLICATION

(11) **EP 3 671 982 A1**
(43) Date of publication of application: **24.06.2020**
(21) Application number: 18215210.8
(22) Date of filing: 21.12.2018
(51) Int. Cl.: H01S 5/22

(54) **III-V-ON-SILICON NANORIDGE OPTO-ELECTRONIC DEVICE WITH A REGROWN FIN STRUCTURE**

(71) Applicant: IMEC vzw, 3001 Leuven (BE)
(72) Inventor: De Koninck, Yannick, 3001 Leuven (BE); Kunert, Bernardette, 3001 Leuven (BE); Van Campenhout, Yoris, 3001 Leuven (BE); Pantouvaki, Maria Ioanna, 3001 Leuven (BE); Kuznetsova, Nadezda, 3001 Leuven (BE)
(74) Representative: Roth, Sebastian

(57) **Abstract**

The present invention relates to the development of a monolithic active electro-optical device. The electro-optical device may be fabricated using the so-called nanoridge aspect ratio trapping (ART) approach. The electro-optical device is a monolithic integrated electro-optical device comprising a first-conductivity-type Si-based support region and a III-V-semiconductor-material ridge structure extending from the Si-based support region, wherein the ridge structure contains a recombination region. Further, the device comprises a III-V-semiconductor capping layer having a higher band-gap than the III-V semiconductor material of the ridge structure and being provided on an outer surface of the ridge structure. The device also comprises at least one second-conductivity-type III-V-semiconductor fin structure narrower than and extending upwards from the top surface of the ridge structure through an opening in the capping layer on the top surface of the ridge structure.

## Description

### TECHNICAL FIELD

The present invention relates to the development of a monolithic active electro-optical device (e.g. a Light Emitting Diode (LED), a LASER, a modulator, or a photo-detector). The electro-optical device may be fabricated using the so-called nanoridge aspect ratio trapping (ART) approach. In particular, the invention proposes a monolithic integrated electro-optical device, which comprises a III-V-semiconductor-material ridge structure provided on a Si-based support region.

### BACKGROUND OF THE INVENTION

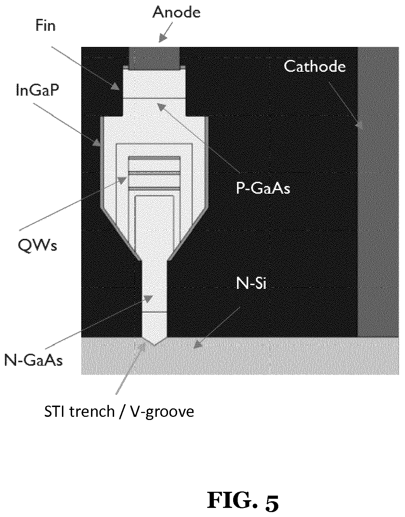

An example of a monolithic integrated electro-optical device fabricated with the nanoridge ART approach is shown in FIG. 5. The electro-optical device includes a III-V semiconductor material (e.g. GaAs) ridge structure, which is grown in a narrow Shallow Trench Isolation (STI) trench on a silicon V-groove formed in a Si support layer. The STI trench has a high aspect ratio (i.e. a ratio of its depth vs. its width is larger than at least 1), which has the advantage that misfits and dislocation defects are efficiently trapped (thus called ART) as soon as the III-V semiconductor material is grown inside the trench, and the outgrown III-V semiconductor ridge material, i.e. the freestanding ridge structure, is free or nearly free of defects.

In the electro-optical device of FIG. 5, the Si support layer is highly n-doped, and is in contact with a metallic interface (the cathode - e.g. realized by a W contact plug). The ridge structure itself comprises:
- An n-doped III-V semiconductor material (e.g. GaAs) region arranged near the bottom of the ridge and contacting the n-doped Si support layer in the trench.
- A not-intentionally doped (NID) III-V semiconductor material (e.g. GaAs) region arranged in the center of the ridge structure, and containing a narrower bandgap active/recombination region (e.g. including one or more quantum wells, or one or more layers of quantum dots).
- A p-doped III-V semiconductor material (e.g. GaAs) region arranged at the top of the ridge structure, which is in contact with a metallic interface (the anode - e.g. realized by a W contact plug).
- A capping layer of a higher band-gap III-V material (e.g. InGaP, lattice matched to e.g. the GaAs) grown around the III-V semiconductor material ridge structure, particularly around a wider portion thereof. The capping layer has a conduction and/or valence band offset, which is sufficiently high to prevent at least one species of charge carriers (i.e. electrons and/or holes) to penetrate into the capping layer and to reach its surface interface with a dielectric, which encapsulate the ridge structure and capping layer.
- A region near the top of the ridge, where III-V semiconductor material was removed by etching, in order to form a narrower portion (referred to as 'fin' or 'fin structure'). The purpose of this fin structure is to push - in operation of the electro-optical device - the optical waveguide mode downwards, i.e. away from the metallic anode. This reduces the modal absorption loss, while still providing a channel for injecting electrical current into the III-V semiconductor material ridge structure, specifically into the active region.

A passive waveguide (e.g. a Si-waveguide) can be brought into close proximity of the active region of the ridge structure, for instance, for evanescent coupling of optical power into and out of the ridge structure.

However, in order to obtain a laser operation of the electro-optical device shown in FIG. 5, a significant amount of charge carriers must be available in the recombination region (e.g. the quantum wells or quantum dots) to recombine radiatively and to support a stimulated emission. Unfortunately, non-radiative recombination processes - such as Shockley-Read-Hall and Auger recombination - provide alternative routes for charge carriers to recombine, and thus reduce the charge carrier density in the laser active region.

In particular, interfaces between untreated III-V semiconductor material (e.g. GaAs) and the surrounding dielectric suffer from high surface Shockley-Read-Hall recombination rates (e.g. the surface recombination velocity may be in the order of 1E+6 cm/s).

Any recombination mechanism is limited by the supply of minority charge carriers. This means for the electro-optical device shown in FIG. 5 that:
- Surface recombination is lower in highly-doped III-V semiconductor material/dielectric interfaces, because minority charge carriers (i.e. electrons in p-doped regions, and holes in n-doped regions) are prevented from penetrating into these regions, due to the strong electric fields present at the depletion region.
- Surface recombination is lower in the capping layer/dielectric interface, because the high valence band offset between the III-V semiconductor material (e.g. GaAs) and the capping layer (e.g. InGaP) will prevent holes from penetrating into the capping layer and from reaching the capping layer/dielectric interface, where they would recombine with electrons.

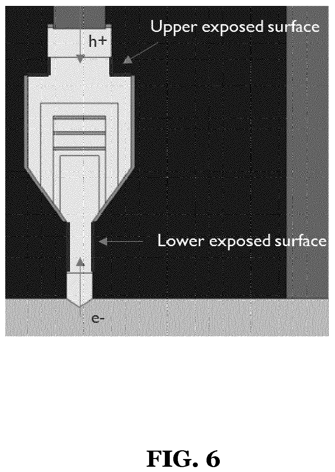

However, FIG. 6 shows that there are still regions in the III-V semiconductor material ridge structure of the electro-optical device, where lowly-doped III-V semiconductor material (e.g. GaAs), which contains significant densities of both electrons and holes, is exposed to the surrounding dielectric. This potentially leads to higher surface recombination rates, which may significantly decrease the laser performance of the electro-optical device, and may even inhibit electrically injected laser operation.

The regions where lowly-doped III-V semiconductor material regions are exposed to the dielectric are in particular:
- The III-V semiconductor material (e.g. GaAs) regions at the top of the ridge structure, which are created by the etching the fin structure (labelled 'upper exposed surface' in FIG. 6).
- The III-V semiconductor material (e.g. GaAs) narrower portion arranged near the bottom of the ridge structure and contacting the n-doped Si layer (labelled 'lower exposed surface' in FIG. 6).

### SUMMARY OF THE INVENTION

In view of the above-mentioned disadvantages, embodiments of the present invention aim to provide an improved electro-optical device. An objective is in particular to provide an electro-optical device with a ridge structure, which shows better lasing abilities. To this end, a main goal is to reduce or even eliminate surface recombination at exposed III-V semiconductor material regions, in order to increase/maximize charge carries densities in the active/recombination region of the device.

The objective is achieved by the embodiments of the invention provided in the enclosed independent claims. Advantageous implementations of these embodiments are defined in the dependent claims.

The embodiments base on the following considerations. In earlier attempts to obtain optically pumped nanoridge lasers, there was no metallic contact interface that caused optical loss, and the problem of surface recombination was tackled by growing a higher band-gap capping layer around the ridge structure. However, to enable electrical injection into the ridge structure, a metallic contact interface to the doped top region of the ridge structure was necessary, which resulted in excessive optical loss. To control this optical loss, the fin structure was provided by etching the ridge structure, so as to push downwards the optical mode, i.e. away from the metallic contact interface. Etching the fin structure also removes a significant amount of the higher band-gap capping layer, which increases considerably the surface recombination rate. In the worst cases, the surface recombination rates increased to a point that made lasing operation no longer possible.

Thus, the embodiments of the present invention base on the idea of not etching the fin structure, but instead growing the fin structure (or multiple fin structures) on the ridge structure.

A first aspect of the invention provides a monolithic integrated electro-optical device, comprising: a first-conductivity-type Si-based support region; a III-V-semiconductor-material ridge structure extending from the Si-based support region, the ridge structure containing a recombination region, a III-V-semiconductor capping layer having a higher band-gap than the III-V semiconductor material of the ridge structure and being provided on an outer surface of the ridge structure, and at least one second-conductivity-type III-V-semiconductor fin structure narrower than and extending upwards from the top surface of the ridge structure through an opening in the capping layer on the top surface of the ridge structure.

In the electro-optical device of the first aspect, the fin structure is not fabricated by etching the ridge structure. As a consequence, unlike in the electro-optical device shown in FIG. 5, there remains capping layer on the top surface of the ridge structure. That means, the amount of capping layer removed from the surface of the ridge structure is much smaller than in the electro-optical device of FIG. 5. Consequently, the top surface of the ridge structure is still largely protected by capping layer, which significantly reduces surface recombination. In particular, the fin structure - and thus also the opening in the top surface capping layer - may be at least 50% narrower than the entire top surface of the ridge structure. This means that at least 50% of the top surface of the ridge structure are still protected by the capping layer. The capping layer may be a NID capping layer, but it can also be doped (first or second conductivity type).

The only exposed interfaces at the top of the electro-optical device are then the interfaces between the fin structure and material surrounding the fin structure, e.g. a surrounding dielectric. However, surface recombination at these interfaces can be largely suppressed by making the fin structure highly-doped. Since the fin structure is also used as a channel to inject charge carriers into the recombination region of the ridge structure, such high doping is anyhow beneficial. The recombination region may be the region, in which the optical mode is concentrated and in which the recombination takes place. The fin structure can additionally function in the same way as the etched fin structure of the electro-optical device shown in FIG. 5, i.e. in operation of the device it pushes the optical mode downwards towards the recombination region.

Notably, in this entire document, the terms "upwards", "top", "above" etc. relate to the terms "downwards", "bottom", "below" etc. according to a fabrication direction, e.g. by epitaxial growth, of the electro-optical device. That is, the "lowest" point of the ridge structure is on the support region, and the support region is "below" the ridge structure. The ridge structure extends "upwards" from the support region, and the fin structure is provide "on top" and "above" the ridge structure.

In the electro-optical device of the first aspect, and also in this entire document, the "first-conductivity-type" may be an n-type or p-type, and the "second-conductivity-type" may respectively be a p-type or n-type. Likewise, "first-conductivity-type charge carriers" may thus be electrons or holes, and "second-conductivity-type charge carriers" may respectively be holes or electrons.

As an overall effect of the above-described features, the electro-optical device of the first aspect shows much better lasing abilities than the electro-optical device shown in FIG. 5.

In an implementation of the electro-optical device, the fin structure is grown onto the top surface of the ridge structure.

In particular, the fin structure is grown through/into the opening formed in the top surface capping layer, which may be produced before the growth of the fin structure, e.g. by etching. In this way, the width and height of the fin structure can be controlled very precisely. Additionally, structural parameters of the fin structure like the doping level and/or band-gap structure can be controlled well during its growth. For instance, the fin structure may be grown epitaxially, particularly by molecular beam epitaxy.

In an implementation of the electro-optical device, a doping level in the fin structure is larger than 1E+17 cm⁻³.

The doping level in the fin structure may even be larger than 1E+18 cm⁻³, or may even larger than 1E+19 cm⁻³. For instance, the doping level in the fin structure may be between 1E+19 cm⁻³ and 1E+20 cm⁻³. The high doping level in the fin structure reduces the surface recombination rate at the interfaces of the fin structure to material (or air) surrounding the fin structure, thus improving the laser efficiency of the device.

In an implementation of the electro-optical device, a doping level in the fin structure increases along the extension of the fin structure in a direction away from the top surface of the ridge structure.

Thus, a metallic electrode can be provided on top of the fin structure, in order to efficiently inject charge carriers through the fin structure into the ridge structure.

In an implementation of the electro optical device, a width of the fin structure varies along an extension direction of the ridge structure.

By modulating the width of the fin structure, a distributed feedback (DFB) like reflector or mirror may be created. Further, a balance between diode series resistance and optical loss may be shifted. In particular, by making the fin structure wider, a wider channel for electrical current to flow into the ridge structure can be provided, but the optical mode will penetrate into the fin structure and may suffer from additional optical loss due to absorption. In advanced Laser concepts, a tuning section, a coupling section or a saturable absorber section of the device could be provided, in which the current level through the ridge structure is lower than in an amplifier section of the device. In this case, for example, the width of the fin structure may be reduced in the non-amplifying sections, in order to reduce optical loss. The penalty suffered from the increased diode series resistance will be minimal, because the current flowing through the fin structure is lower than in the amplifying section.

In an extreme case of the varying width of the fin structure, the width of the fin structure may also become zero in some locations, meaning that in some locations there is no fin structure, i.e. one or more gaps are formed between separate fin structures. Accordingly, in an implementation, the electro-optical device may comprise a plurality of the second-conductivity-type III-V-semiconductor fin structures, wherein the fin structures extend upwards from the top surface of the ridge structure, each through an associated opening in the capping layer on the top surface of the ridge structure. The fin structures may therby be arranged one after the other along the extension direction of the ridge structure.

In other words, a fin structure may be provided only in selected parts of the top surface of the ridge structure (along the extension direction of the ridge structure). For example, along the ridge structure, there may be a part, e.g. 1 µm long, with a fin structure, followed by another part, e.g. 1 µm long, without a fin structure, and so on. A pitch between the parts with and without fin structure may depend on the ridge structure design.

In an implementation of the electro-optical device, the ridge structure, capping layer and fin structure are surrounded by a dielectric, and the fin structure is grown in a trench into the dielectric above the ridge structure.

For instance, the trench may be etched into the dielectric. The etching of the dielectric trench also creates the opening in the top surface capping layer. The trench can guide the subsequent growth of the fin structure, such that the fin structure in the completed electro-optical device is precisely arranged in the opening of the capping layer. This avoids any unnecessary exposed surfaces.

In an implementation, the electro-optical device further comprises a first electrode electrically contacting the fin structure and configured to inject second-conductivity-type charge carriers into the ridge structure, and a second electrode electrically contacting the support region and configured to inject first-conductivity-type charge carriers into the ridge structure.

The first and second electrodes are notably also able to collect excess charge carriers (i.e. those injected charge carriers that did not recombine in the recombination region). In particular, the first electrode may collect first-conductivity-type charge carriers and the second electrode may collect second-conductivity-type charge carriers.

Preferably, the first electrode is provided on the top surface of the fin structure, because in this position it is (spatially) the furthest away from the optical mode (concentrated in the recombination region), which leads to the lowest optical loss. As mentioned above, the fin structure may be grown such that the doping density at its top is the highest, in order to ensure a particularly good electrical interface between the III-V semiconductor material of the fin structure and the electrode, e.g. realized by a contact metal.

The Si-based support region may be a first-conductivity-type doped region, which is arranged in a top part of a Si-based substrate. The first-conductivity-type Si-based support region is in this case electrically connected to the interface between the III-V semiconductor ridge material and the Si substrate, such that a current can flow. The Si-based substrate may be a Silicon on Insulator (SOI) substrate.

In an implementation of the electro-optical device, the ridge structure is partly arranged in a trench formed in the support region and/or the ridge structure is grown onto a V-groove formed in the support region.

Accordingly, the electro-optical device can be fabricated using the ART approach. To this end, the trench formed in the support region preferably has an aspect ratio of larger than 1, more preferably larger than 1.5, most preferably larger than 3, wherein the aspect ratio is defined by its depth into the support region over its width. In this way, misfits and dislocation defects are efficiently trapped in the trench at the very bottom of the III-V semiconductor material ridge structure, such that the remaining, outgrown III-V semiconductor ridge structure is free or nearly free of defects. This leads to a better lasing ability of the device.

In an implementation of the electro-optical device, the ridge structure comprises a narrower portion arranged on the support region and a wider portion arranged on top of the narrower portion.

The narrower portion may form a foot of the ridge structure, which is grown in the STI trench on the Si V-groove of the Si based support region, i.e. using the ART approach. The wider portion may be a body of the ridge structure that is supported on the foot. The wider portion may include the recombination region. The wider structure may include a vertical PiN or NiP diode structure, where the recombination region is in the intrinsic part. In particular, the wider portion may include a first-conductivity-type bottom region, a NID intermediate region provided on the top and possibly on the side surfaces of the bottom region, wherein the intermediate region contains the recombination region, and a second-conductivity-type top region provided on the top and possibly on the side surfaces of the intermediate region. The wider portion may be surrounded by the capping layer. The narrower portion may be of the first-conductivity type, particularly near the wider portion.

In an implementation of the electro-optical device, the ridge structure comprises one or more quantum wells and/or quantum dots and/or quantum wires in the recombination region.

Although the quantum wells/wires/dots are provided for the purpose of more efficient charge carrier recombination, such recombination can also happen in the material surrounding these low-dimensional structures. That is, there can be parts of the ridge structure that are not the quantum wells/wires/dots etc., but can still contribute to the recombination. In particular, if the ridge structure includes a vertical PiN or NiP structure. Charge carriers can, for example, also recombine in the bulk area of the above-described intermediate region (i.e. the material surrounding the quantum wells/wires/dots). However, the carrier density in this area is usually orders of magnitude lower than the carrier density in the quantum wells/wires/dots. Moreover, the wavelength emitted due to the charge carriers recombining in that surrounding area will be significantly lower, due to the higher bandgap, than the wavelengths emitted by recombination in the narrower bandgap quantum wells/wires/dots.

In an implementation, the electro-optical device is a Laser, a Light Emitting Diode, or an optical amplifier.

A second aspect of the invention provides a method for fabricating a monolithic integrated electro-optical device, the method comprising: providing a first-conductivity-type Si-based support region; growing a III-V-semiconductor-material ridge structure containing a recombination region onto the support region, growing a III-V-semiconductor capping layer having a higher band-gap than the III-V semiconductor material of the ridge structure onto an outer surface of the ridge structure, forming a gap in the capping layer to expose a part of the top surface of the ridge structure, and growing at least one second-conductivity-type III-V-semiconductor fin structure narrower than the top surface of the ridge structure onto the exposed part of the top surface of the ridge structure.

In an implementation, the method further comprises surrounding the ridge structure by a dielectric, after growing the capping layer, and etching a trench into the dielectric above the ridge structure and into the capping layer to form the gap.

In an implementation, the method further comprises growing the fin structure in the trench etched into the dielectric and onto the exposed part of the top surface.

In an implementation of the method, growing the fin structure comprises increasing the doping level with progressing growth.

In an implementation of the method, growing the ridge structure includes growing a second-conductivity-type layer of III-V semiconductor material below the top surface of the ridge structure.

The method of the second aspect and its implementations achieve the same advantages as the device of the first aspect and its respective implementations described above.

### BRIEF DESCRIPTION OF THE DRAWINGS

The above described aspects and implementations are explained in the following description of embodiments with respect to the enclosed drawings:
- FIG. 1: shows an electro-optical device according to an embodiment of the invention.
- FIG. 2: shows in (a) an electro-optical device according to an embodiment of the invention, and in (b) a doping density in the electro-optical device.
- FIG. 3: shows a method according to an embodiment of the invention.
- FIG. 4: shows a parameter comparison between an etched fin structure and a (re-)grown fin structure.
- FIG. 5: shows an example of a III-V-on-Si ridge electro-optical device.
- FIG. 6: shows an example of a III-V-on-Si ridge electro-optical device, with indicated carrier flows and exposed III-V surfaces.

### DETAILED DESCRIPTION OF EMBODIMENTS OF THE INVENTION

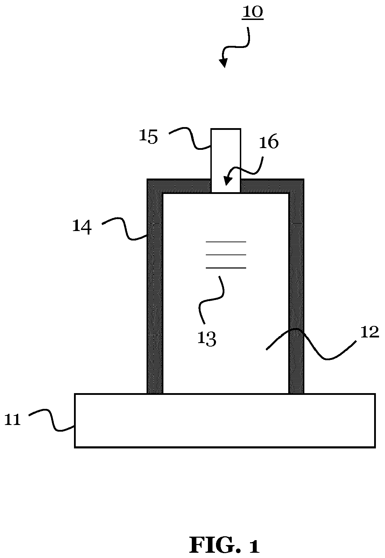

FIG. 1 shows a monolithic integrated electro-optical device 10 according to an embodiment of the invention, in particular a cross-section of the electro-optical device 10. The device 10 is particularly a III-V-on-Si ridge electro optical device. The electro-optical device 10 of FIG. 1 may in particular be a Laser, a LED, or an optical amplifier. The electro-optical device 10 may be fabricated using the nanoridge ART approach.

The device 10 particularly comprises a first-conductivity-type Si-based support region 11. The support region 11 may be a Si or Si-based (e.g. SiN) substrate. The support region 11 may also be a first-conductivity-type top region of an intrinsic Si or Si-based substrate, particularly of a SOI substrate.

The device 10 further comprises a III-V-semiconductor-material ridge structure 12 extending from the Si-based support region 11, wherein the ridge structure 12 contains a recombination region 13. The ridge structure 12 may be fabricated using the ART approach on the support region 11, i.e. may be grown in a high-aspect-ratio trench formed before in the support region. The ridge structure 12 may extend on the support region 11 along a direction, which is into the plane in the cross-section shown in FIG. 1.

The device 10 further comprises a III-V-semiconductor capping layer 14 having a higher band-gap than the III-V semiconductor material of the ridge structure 12 and being provided on an outer surface of the ridge structure 12. In FIG. 1, the capping layer 14 is shown to encapsulate the ridge structure 12. However, the capping layer 14 may also surround only part of the ridge structure 12, i.e. may only be provided on parts of the outer surface of the ridge structure 12. In particular, in some embodiments the ridge structure 12 comprises a narrower portion arranged on the support region 11, and a wider portion carried on the narrower portion. In this case, the capping layer 14 may at least be provided on the outer surface of the wider portion.

The device 10 finally comprises at least one second-conductivity-type III-V-semiconductor fin structure 15, which is narrower than and extends upwards from the top surface of the ridge structure 12. In particular, it extends upwards through an opening 16 formed in the capping layer 15, which is provided on the top surface of the ridge structure 12. After the forming of this opening, capping layer material remains on the top surface on both sides of the opening. The fin structure 15 may be at least 50% narrower than the width of the top surface of the ridge structure, i.e. it may be half as wide as the ridge structure at its top surface. The fin structure 15 may even be 60%, 70% or even 80% narrower than the top surface of the ridge structure 12. Along the extension direction of the ridge structure 12 (i.e. into the plane in FIG. 1), the width of the fin structure 15 (left-right extension of the fin structure 15 in FIG. 1) may vary. For instance, the fin structure 15 width may vary periodically from wider to narrower and again wider. Along the extension direction of the ridge structure 12, there may even be arranged a plurality of fin structures 15 one after the other. In particular, there may be selected parts without fin structure 15 on the top surface of the ridge structure 12, and other selected parts with fin structure 15 on the top surface of the ridge structure 12. This arrangement can also be considered as a fin structure 15 with varying width along the extension direction of the ridge structure 12, wherein the width becomes zero in selected parts.

Since there is capping layer material on the top surface of the ridge structure 12, in the device 10 according to an embodiment of the invention, the fin structure 15 is not formed by etching as in the device shown in FIG. 5, but is provided on top of the ridge structure 12 after the ridge structure 12 and the capping layer 14 are made. In particular, the fin structure 12 may be regrown, i.e. grown on the ridge structure 12 after the ridge structure 12 is grown, and after an opening in the capping layer 14 on the ridge structure 12 is formed.

In the electro-optical device 10 shown in FIG. 1, the first-conductivity-type may be n-type and the second-conductivity-type p-type. First-conductivity-type charge carriers are thus electrons, and second-conductivity-type charge carriers are holed. However, these polarities could also be exchanged.

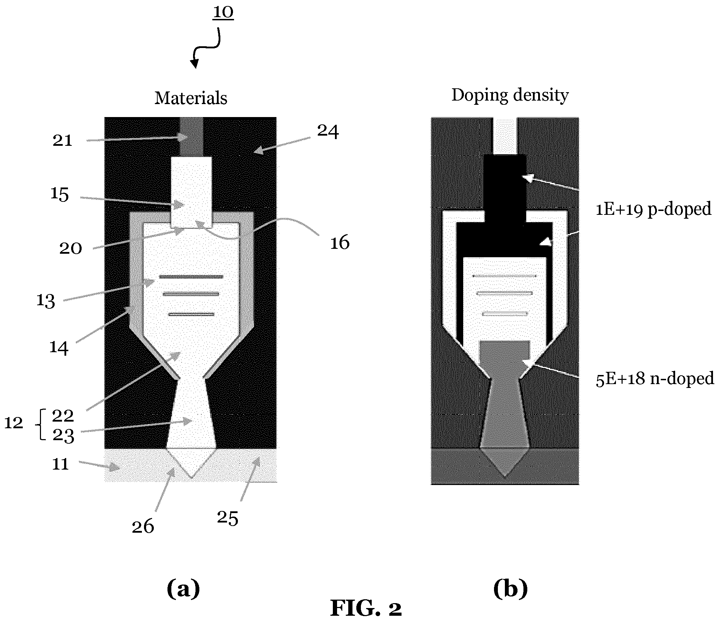

FIG. 2 shows in (a) an electro-optical device 10 according to an embodiment of the invention, in particular a cross-section of the electro-optical device, which builds on the device 10 shown in FIG. 1. Further, FIG. 2 shows in (b) an exemplary doping density in the device 10 shown in (a). FIG. 2 (b) exemplarily assumes that the first-conductivity-type is n-type, and the second-conductivity-type is p-type. Same elements in FIG. 1 and FIG. 2 share the same reference signs and function likewise. Accordingly, also the device 10 shown in FIG. 2 (a) includes the Si-based support region 11, the III-V semiconductor material ridge structure 12, the III-V semiconductor capping layer 14, and the fin structure 15.

FIG. 2 further shows that the ridge structure 12 may include a narrower portion 23 arranged on the support region 11, e.g. in a STI trench and/or V-groove 26 formed in the support region 11, and a wider portion 22 arranged on top of the narrower portion 23. That is the wider portion 22 is freestanding supported by the narrower portion 23. The ridge structure 12 in other words is a freestanding ridge structure with a narrower foot and a wider body.

Further, FIG. 2 shows that the ridge structure 12, the capping layer 14 and the fin structure 15 may be surrounded by a dielectric 24, e.g. an oxide like SiO₂. In particular, the fin structure 15 may be grown in a trench, which is provided in (e.g. etched into) the surrounding dielectric 24, wherein the dielectric trench is arranged above the ridge structure 12.

Further, the electro-optical device 10 may include a first electrode 21, which is in electrical contact with the fin structure 15. The first electrode 21 is particularly configured to inject second-conductivity-type charge carriers into the ridge structure 12, and also to collect excess first-conductivity-type charge carriers from the ridge structure 12, i.e. such first-conductivity-type charge carriers that did not recombine in the recombination region 13. The device 10 may also include a second electrode 25, which is in electrical contact with the support region 11. The second electrode 25 is configured to inject first-conductivity-type charge carriers into the ridge structure 12, and also to collect excess second-conductivity-type charge carriers from the ridge structure 12, i.e. such second-conductivity-type charge carriers that were injected by the first electrode 21 and did not recombine in the recombination region 13 with the first-conductivity-type charge carriers injected by the second electrode 25. The first and/or the second electrode may be a metal contact or plug, e.g. formed by using W, Cu or another suitable metal.

Like in the device 10 shown in FIG. 1, also in the device 10 of FIG.2 the fin structure 15, which is in particular not obtained by etching it from/out of the ridge structure 12, but the fin structure 15 is grown on top of the ridge structure 12, i.e. it is regrown after growing and further preparing the ridge structure 12. Thereby, a ridge structure/fin structure interface 20 is formed. A fabrication of the device 10, and in particular of the fin structure 15, may thus include the following steps:
- Before growing the capping layer 14 (e.g. based on InGaP), a sufficiently thick highly-doped layer of second-conductivity-type III-V semiconductor material (e.g. p-doped GaAs) may be grown as top region of the ridge structure 12. After that, the capping layer 14 is grown onto an outer surface of the ridge structure 12.
- After growing the III-V-semiconductor-material ridge structure 12, the dielectric 24 is deposited, in order to fill the space around and above the ridge structure 12 (and the capping layer 14).
- The dielectric 24 may then be planarized (e.g. by using Chemical Mechanical polishing (CMP)), while preferably still keeping a sufficiently thick layer of dielectric 24 above the III-V ridge structure 12.
- Above the ridge structure 12, a narrow trench may then be formed, particularly etched, into the dielectric 24. Thereby, a part of the top surface of the III-V ridge structure is exposed.
- In the trench, also the capping layer 14 (e.g. InGaP) is removed, in order to expose the highly-doped second-conductivity-type layer of the ridge structure 12 mentioned above. Notably, the capping layer 14 may be removed by the dielectric etching step or by a separate step of e.g. selective capping layer etching.
- A second selective area epitaxy step (referred to as the 'regrowth' step) may then be performed, in order to fill the newly created narrow trench in the dielectric 24 with preferably highly-doped second-conductivity-type III-V semiconductor material. This step creates the fin structure 15. The doping density can be gradually or step-wise increased in this step, i.e. as the III-V semiconductor material fills the trench, i.e. as the growth of the fin structure 15 progresses.
- After the regrowth step of the fin structure 15, another planarization step can be carried out, and the fabrication process may proceed with standard contact and metallization steps, e.g. to provide the first electrode 21 and/or second electrode 25.

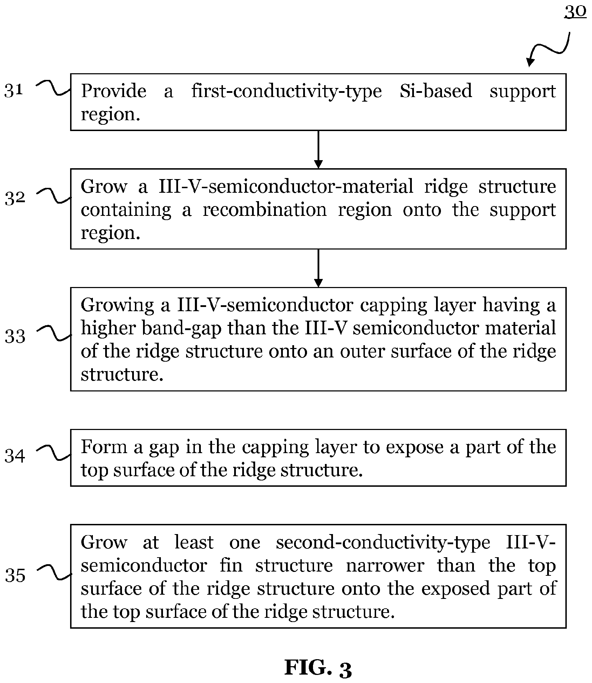

FIG. 3 shows schematically a method 30 for fabricating the device 10 according to an embodiment of the invention. The method 30 includes at least the following steps. A step 31 of providing a first-conductivity-type Si-based support region 11. A step 32 of growing a III-V-semiconductor-material ridge structure 12 containing a recombination region 13 onto the support region 11. A step 33 of growing a III-V-semiconductor capping layer 14 having a higher band-gap than the III-V semiconductor material of the ridge structure 12 onto an outer surface of the ridge structure 12. A step 34 of forming an opening in the capping layer 14 to expose a part of the top surface of the ridge structure 12. A step 35 of growing at least one second-conductivity-type III-V-semiconductor fin structure 15 narrower than the top surface of the ridge structure 13 onto the exposed part of the top surface of the ridge structure 12.

Notably, with the method 30, a plurality of electro-optical devices 10 may be fabricated in parallel, particularly by providing a plurality of ridge structures 12 at the same time next to another on the Si-based support region. For instance, the Si-based support region 11 may belong to (or be) a full wafer, particularly a 200 mm or 300 mm wafer. The wafer may finally be diced, in order to separate individual electro-optical devices 10. If the ART approach is used to produce the electro-optical devices 10, a plurality of STI trenches may be formed in the support region 11, and a ridge structure 12 may be epitaxially grown in each of the STI trenches. The method 30 is, due to its relative simplicity, able to achieve high yields of fabricating the electro-optical devices 10.

The advantages provided by the above-described embodiments of the electro-optical device 10 and method 30 are at least those listed below:
- The regrown fin structure 15 may be designed much narrower than the ridge structure 12 (top surface), which allows it to more effectively act as a fin forcing the optical mode down into the ridge structure 12, and keeping it away from e.g. a metallic contact on top of the fin structure 15.
- Unlike in the fin etching approach described with respect to FIG. 5 and FIG. 6, the amount of removed capping layer material (e.g. the InGaP) is very small on the top surface of the ridge structure 12. This means that the ridge structure 12 is still largely protected by the capping layer 14 from surface recombination, in particular everywhere except for in the trench that serves as a seed for the regrown fin structure 15. The interface between the regrown fin structure 15 and the surface of the dielectric 24 is exposed, but if the regrown fin structure 15 is doped sufficiently high (e.g. with a second-conductivity-type doping of > 1E+19 cm⁻³), the electric field resulting at the depletion region between ridge structure 12 and fin structure 15 will be sufficiently strong to keep first-conductivity-type charge carriers from reaching into the regrown fin structure 15 and causing surface recombination.
- Preferably, either side of the ridge structure/fin structure interface 20 is highly doped (second-conductivity-type). The higher charge carrier concentration will result in narrower potential barriers, which are easier to tunnel through, thus significantly improving the quality of the electric interface 20.
- Moreover, by making sure that the top region of the ridge structure 12 is already highly-doped (second-conductivity type), the intrinsic/doped interface is arranged well below the ridge structure/regrown fin structure interface 20, thus preventing that first-conductivity-type charge carriers reach the ridge structure/fin structure interface and cause non-radiative charge carrier recombination.

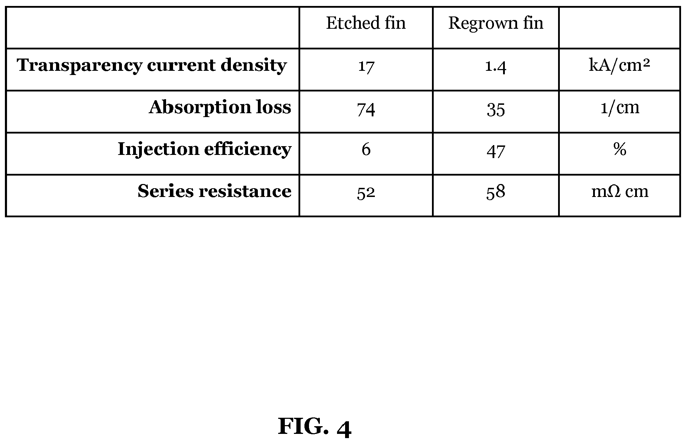

FIG. 4 shows an overview of some parameters of the electro-optical device 10 including the regrown fin structure 15 comparison to the example device with the etched fin structure. It can be seen from the table shown in FIG. 4 that the device 10 according to embodiments of the present invention shows better (lower) transparency current density, lower absorption loss, higher injection efficiency, and only a marginally higher series resistance.

In summary, the embodiments of the invention base on forming the fin structure 15 on the ridge structure 12, instead of etching it from the ridge structure 12. Thus, the laser mode of the electro-optical device 10 will have lower absorption loss, because on the one hand the mode is pushed away from the electrode 21, but still has acceptable injection efficiency, because non-radiative recombination at the surface or defects is prevented.

## Claims

1. Monolithic integrated electro-optical device (10), comprising:
a first-conductivity-type Si-based support region (11);
a III-V-semiconductor-material ridge structure (12) extending from the Si-based support region (11), the ridge structure (12) containing a recombination region (13),
a III-V-semiconductor capping layer (14) having a higher band-gap than the III-V semiconductor material of the ridge structure (12) and being provided on an outer surface of the ridge structure (12), and
at least one second-conductivity-type III-V-semiconductor fin structure (15) narrower than and extending upwards from the top surface of the ridge structure (12) through an opening (16) in the capping layer (15) on the top surface of the ridge structure (12).

2. Electro-optical device (10) according to claim 1, wherein:
the fin structure (15) is grown onto the top surface of the ridge structure (12).

3. Electro-optical device (10) according to claim 1 or 2, wherein:
a doping level in the fin structure (15) is larger than 1E+17 cm⁻³.

4. Electro-optical device (10) according to one of the claims 1 to 3, wherein:
a doping level in the fin structure (15) increases along the extension of the fin structure (15) in a direction away from the top surface of the ridge structure (12).

5. Electro optical device (10) according to one of the claims 1 to 4, wherein:
a width of the fin structure (15) varies along an extension direction of the ridge structure (12).

6. Electro-optical device (10) according to one of the claims 1 to 5, wherein:
the ridge structure (12), capping layer (14) and fin structure (15) are surrounded by a dielectric (24), and
the fin structure (15) is grown in a trench into the dielectric (24) above the ridge structure (12).

7. Electro-optical device (10) according to one of the claims 1 to 6, further comprising:
a first electrode (21) electrically contacting the fin structure (15) and configured to inject second-conductivity-type charge carriers into the ridge structure (12), and
a second electrode (25) electrically contacting the support region (11) and configured to inject first-conductivity-type charge carriers into the ridge structure (12).

8. Electro-optical device (10) according to one of the claims 1 to 7, wherein:
the ridge structure (12) is partly arranged in a trench formed in the support region and/or
the ridge structure is grown onto a V-groove formed in the support region.

9. Electro-optical device (10) according to one of the claims 1 to 8, wherein:
the ridge structure (12) comprises a narrower portion (23) arranged on the support region (11) and a wider portion (22) arranged on top of the narrower portion (23).

10. Electro-optical device (10) according to one of the claims 1 to 9, wherein:
the ridge structure (12) comprises one or more quantum wells and/or quantum dots and/or quantum wires in the recombination region (13).

11. Electro-optical device (10) according to one of the claims 1 to 10, being:
a Laser, a Light Emitting Diode, or an optical amplifier.

12. Method (30) for fabricating a monolithic integrated electro-optical device (10), the method (30) comprising:
providing (31) a first-conductivity-type Si-based support region (11);
growing (32) a III-V-semiconductor-material ridge structure (12) containing a recombination region (13) onto the support region (11),
growing (33) a III-V-semiconductor capping layer (14) having a higher band-gap than the III-V semiconductor material of the ridge structure (12) onto an outer surface of the ridge structure (12),
forming (34) an opening in the capping layer (14) to expose a part of the top surface of the ridge structure (12), and
growing (35) at least one second-conductivity-type III-V-semiconductor fin structure (15) narrower than the top surface of the ridge structure (13) onto the exposed part of the top surface of the ridge structure (12).

13. Method (30) according to claim 12, further comprising:
surrounding the ridge structure (12) by a dielectric (24), after growing the capping layer (14), and
etching a trench into the dielectric (24) above the ridge structure (12) and into the capping layer (14) to form the opening.

14. Method (30) according to claim 13, further comprising:
growing (35) the fin structure (15) in the trench etched into the dielectric (24) and onto the exposed part of the top surface.

15. Method (30) according to one of the claims 12 to 14, wherein:
growing (35) the fin structure (15) comprises increasing the doping level with progressing growth.

16. Method (30) according to one of the claims 12 to 15, wherein:
growing (32) the ridge structure (12) includes growing a second-conductivity-type layer of III-V semiconductor material below the top surface of the ridge structure (12).
